# EUROPEAN PATENT APPLICATION

(11) **EP 3 982 172 A1**
(43) Date of publication of application: **13.04.2022**
(21) Application number: 19932063.1
(22) Date of filing: 31.12.2019
(51) Int. Cl.: G02B 5/28

(54) **NEAR-INFRARED NARROWBAND FILTER AND MANUFACTURING METHOD THEREFOR**

(30) Priority: 05.06.2019 CN 201910487259
(71) Applicant: Xin Yang Sunny Optics Co., Ltd., Xinyang, Henan 464006 (CN)
(72) Inventor: XIAO, Niangong, Xinyang Henan 464006 (CN); FANG, Yeqing, Xinyang Henan 464006 (CN); DING, Weihong, Xinyang Henan 464006 (CN); CHEN, Ce, Xinyang Henan 464006 (CN)
(74) Representative: Müller-Boré & Partner Patentanwälte PartG mbB
(86) International application number: PCT/CN2019/130539
(87) International publication number: WO 2020/244219

(57) **Abstract**

The present disclosure provides a near-infrared narrowband filter (5) and a manufacturing method therefor. The filter (5) includes: a substrate (11); a set of narrowband pass films (12), disposed at a first side of the substrate (11); and a set of wideband pass films (13) or a set of longwave pass films (13). The set of wideband pass films (13) is disposed at a second side of the substrate (11) opposite to the first side, a passband of the set of wideband pass films (13) is wider than that of the set of narrowband pass films (12), the set of longwave pass films (13) is disposed at the second side of the substrate (11) opposite to the first side, and a passband of the set of longwave pass films (13) is wider than that of the set of narrowband pass films (12). The set of narrowband pass films (12) includes a high refractive index layer (121) having a refractive index greater than 3 and a low refractive index layer (122) having the refractive index less than 3 within a wavelength range of 780 nm to 3000 nm. A reflection color of the near-infrared narrowband filter (5) in a CIE xyz coordinate system satisfies: x < 0.509, y < 0.363, and z < 50%. The solution of the present disclosure may obtain a near-infrared narrowband filter (5) having diversified reflection colors, low reflection energy intensity, and low reflection color brightness, thereby meeting the application requirements of an under-screen device in the full screen of a mobile phone and an on-board device.

## Description

### CROSS-REFERENCE TO RELATED APPLICATION

This application claims priority to Chinese Patent Application, with the Application No. 201910487259.6 and the title "Near-infrared Narrowband Filter and Manufacturing Method", filed before the China National Intellectual Property Administration (CNIPA) on June 5, 2019, the disclosure of which is hereby incorporated by reference in its entirety.

### TECHNICAL FIELD

The present disclosure relates to the field of optical elements, and specifically, relates to a near-infrared narrowband filter and a manufacturing method therefor.

### BACKGROUND

With the advancement and development of science and technology, filters have been widely used in some terminals with facial recognition or gesture recognition functions, such as smart phone, on-board lidar, security access control, smart home, virtual reality/augmented reality/mixed reality, 3D somatosensory game, 3D camera and display, and other terminal devices.

However, when the existing filter is applied to the terminal device, the problem of light reflection occurs. Therefore, there is a need for filters with better performance in order to be better applied to terminal device.

### SUMMARY

Aiming at the technical problems existing in the prior art, the examples of the present disclosure provide a near-infrared narrowband filter and a manufacturing method therefor.

In a first aspect, an example of the present disclosure provides a near-infrared narrowband filter, including: a substrate; a set of narrowband pass films disposed at a first side of the substrate; and a set of wideband pass films or a set of longwave pass films, wherein the set of wideband pass films is disposed at a second side of the substrate opposite to the first side, the passband of the set of wideband pass films is wider than that of the set of narrowband pass films, the set of longwave pass films is disposed at the second side of the substrate opposite to the first side, and the passband of the set of longwave pass films is wider than that of the set of narrowband pass films. The set of narrowband pass films includes a high refractive index layer having a refractive index greater than 3 and a low refractive index layer having a refractive index less than 3 within a wavelength range of 780 nm to 3000 nm. In a CIE xyz coordinate system, a reflection color of the near-infrared narrowband filter satisfies: x < 0.509; y < 0.363; and z < 50%.

According to the embodiment of the present disclosure, in the CIE xyz coordinate system, the reflection color of the near-infrared narrowband filter satisfies: x < 0.509; y < 0.363; and z < 30%.

According to the embodiment of the present disclosure, the set of narrowband pass films further includes a middle refractive index layer, wherein a refractive index of the middle refractive index layer is between the refractive index of the high refractive index layer and the refractive index of the low refractive index layer.

According to the embodiment of the present disclosure, the high refractive index layer is formed by one or more of hydrogenated silicon, SiₓGe₁₋ₓ and SiₓGe₁₋ₓ: H, or the high refractive index germanium-based layer is formed by one or more of germanium hydride, SiₓGe₁₋ₓ and SiₓGe₁₋ₓ: H.

According to the embodiment of the present disclosure, the low refractive index layer is formed by one or more of SiO₂, Si₃N₄, SiOₓN_{y}, Ta₂O₅, Nb₂O₅, TiO₂, Al₂O₃, SiCN and SiC.

According to the embodiment of the present disclosure, the near-infrared narrowband filter further includes a plurality of middle refractive index layers having a refractive index ranging from 1.7 to 4.5 in the wavelength range of 780 nm to 3000 nm.

According to the embodiment of the present disclosure, the middle refractive index layer is formed by one or more of hydrogenated amorphous silicon oxide (a-SiOₓ:H_{y}), hydrogenated amorphous silicon nitride (a-SiNₓ:H_{y}), hydrogenated amorphous germanium oxide (a-GeOₓ:H_{y}), hydrogenated amorphous germanium nitride (a-GeNₓ:H_{y}), hydrogenated amorphous silicon germanium oxide (a-Si_{z}Ge_{1-z}Oₓ:H_{y}) and hydrogenated amorphous silicon germanium nitride (a-Si_{z}Ge_{1-z}Nₓ:H_{y}).

According to the embodiment of the present disclosure, a center wavelength shift of the passband of the set of narrowband pass films is below 16 nm when an incident light enters the near-infrared narrowband filter at an angle of 0° to 30°.

According to the embodiment of the present disclosure, center wavelength drifts of the *p* light and the *s* light of the near-infrared narrowband filter are below 5 nm.

According to the embodiment of the present disclosure, a total thickness of the set of narrowband pass films and the set of wideband pass films or the set of longwave pass films is less than 15 µm.

In a second aspect, an example of the present disclosure provides a manufacturing method of a near-infrared narrowband filter, including: coating alternately a low refractive index layer and a high refractive index layer on a first side of a substrate to form a set of narrowband pass films, and coating a set of wideband pass films or a set of longwave pass films on a second side of the substrate opposite to the first side. A passband of the set of wideband pass films or the set of longwave pass films is wider than that of the set of narrowband pass films. The set of narrowband pass films includes a high refractive index layer having a refractive index greater than 3 and a low refractive index layer having a refractive index less than 3 within a wavelength range of 780 nm to 3000 nm. In a CIE xyz coordinate system, a reflection color of the near-infrared narrowband filter satisfies: x < 0.509; y < 0.363; and z < 50%.

According to the embodiment of the present disclosure, the manufacturing method is a coating method by sputtering coating or evaporation coating.

According to the embodiment of the present disclosure, forming the set of narrowband pass films further includes: coating a middle refractive index layer, wherein a refractive index of the middle refractive index layer is between the refractive index of the high refractive index layer and the refractive index of the low refractive index layer.

According to the embodiment of the present disclosure, the method further includes: bombarding a target with a charged ion beam obtained by glow discharge based on silicon, germanium, argon, hydrogen, and oxygen to coat a middle refractive index layer, wherein the middle refractive index layer includes one or more of a-SiOₓ:H_{y}, a-SiNₓ:H_{y}, a-GeOₓ:H_{y}, a-GeNₓ:H_{y}, a-SizGe_{1-z}Oₓ:H_{y} and a-Si_{z}Ge_{1-z}Nₓ:H_{y.}

According to the near-infrared narrowband filter and the manufacturing method thereof provided by examples of the present disclosure, a set of narrowband pass films with a high refractive index layer having a refractive index greater than 3 and a low refractive index layer having a refractive index less than 3 within a wavelength range of 780 nm to 3000 nm is disposed on a first side of a substrate, and a set of wideband pass films with a high refractive index layer having the refractive index greater than 3 and a low refractive index layer having the refractive index less than 3 within the wavelength range of 780 nm to 3000 nm is disposed on a second side of the substrate. A passband of the set of wideband pass films is wider than that of the set of narrowband pass films to form the set of narrowband pass films and the set of longwave pass films that satisfy the dark reflection color condition of z < 50% and x < 0.509 and y < 0.363 in the filter coating structure. Therefore, the near-infrared narrowband filter having diversified reflection colors, low reflection energy intensity, and low reflection color brightness can be obtained, thereby meeting the application requirements of an under-screen device in the full screen of a mobile phone and an on-board device.

### BRIEF DESCRIPTION OF THE DRAWINGS

Other features, objects, and advantages of the present disclosure will become more apparent by reading the detailed description of the non-limiting examples with reference to the accompanying drawings:
FIG. 1 is a schematic structural view of a near-infrared narrowband filter provided by an example of the present disclosure;
FIG. 2 is a flowchart of a manufacturing method of the near-infrared narrowband filter provided by an example of the present disclosure;
FIG. 3a is a diagram showing a relationship between reflectivity and wavelength of a bright reflection color narrowband filter provided in example 1 of the present disclosure;
FIG. 3b is a diagram showing a relationship between reflectivity and wavelength of a dark reflection color narrowband filter provided in example 1 of the present disclosure;
FIG. 4a is a diagram showing a relationship between reflectivity and wavelength of a bright reflection color narrowband filter provided in example 2 of the present disclosure;
FIG. 4b is a diagram showing a relationship between reflectivity and wavelength of a dark reflection color narrowband filter provided in example 2 of the present disclosure;
FIG. 5a is a diagram showing a relationship between reflectivity and wavelength of a bright reflection color narrowband filter provided in example 3 of the present disclosure;
FIG. 5b is a diagram showing a relationship between reflectivity and wavelength of a dark reflection color narrowband filter provided in example 3 of the present disclosure;
FIG. 6a is a diagram showing a relationship between reflectivity and wavelength of a dark reflection color narrowband filter provided in example 4 of the present disclosure;
FIG. 6b is a diagram showing a relationship between reflectivity and wavelength of a dark reflection color narrowband filter provided in example 4 of the present disclosure; and
FIG. 7 is a structural view of an optical system provided by an example of the present disclosure.

### DETAILED DESCRIPTION OF EMBODIMENTS

For a better understanding of the present disclosure, various aspects of the present disclosure will be described in more detail with reference to the accompanying drawings. It should be understood that the detailed description is merely illustrative of the exemplary embodiments of the present disclosure and is not intended to limit the scope of the present disclosure in any way. Throughout the specification, the same reference numerals refer to the same elements. The expression "and/or" includes any and all combinations of one or more of the associated listed items.

It should be noted that in the present specification, the expressions such as first, second, third are used merely for distinguishing one feature from another, without indicating any limitation on the features. Thus, a first side discussed below may also be referred to as a second side without departing from the teachings of the present disclosure, and vice versa.

In the accompanying drawings, the thickness, size and shape of the component have been somewhat adjusted for the convenience of explanation. The accompanying drawings are merely illustrative and not strictly drawn to scale. For example, the ratio between the thickness and the length of the first set of films is not in accordance with the ratio in actual production. As used herein, the terms "approximately," "about," and similar terms are used as approximate terms, not as terms representing degree, and are intended to describe inherent deviations in the value that will be recognized, measured or calculated by those of ordinary skill in the art.

Herein, the thickness of the film layer refers to the thickness in the direction away from the substrate.

It should be further understood that the terms "comprising," "including," "having," "containing" and/or "contain," when used in the specification, specify the presence of stated features, elements and/or components, but do not exclude the presence or addition of one or more other features, elements, components and/or combinations thereof. In addition, expressions, such as "at least one of," when preceding a list of features, modify the entire list of features rather than an individual element in the list. Further, the use of "may," when describing embodiments of the present disclosure, refers to "one or more embodiments of the present disclosure." Also, the term "exemplary" is intended to refer to an example or illustration.

Unless otherwise defined, all terms (including engineering terms and scientific and technological terms) used herein have the same meaning as commonly understood by those of ordinary skill in the art to which the present disclosure belongs. It will be further understood that terms, those defined in commonly used dictionaries, should be interpreted as having a meaning that is consistent with the meaning in the context of the relevant art and will not be interpreted in an idealized or overly formal sense, unless expressly so defined herein.

It should also be noted that, the examples in the present disclosure and the features in the examples may be combined with each other on a non-conflict basis. In addition, unless clearly defined or contradictory to the context, the specific steps included in the method described in the present disclosure are not necessarily limited to the described order, and can be executed in any order or in parallel. The present disclosure will be described in detail below with reference to the accompanying drawings and in combination with the examples.

Existing near-infrared narrowband filters use interference principles and combine the absorption characteristics of materials to achieve specific narrowband characteristics, such as passband bandwidth, passband reflectivity, high cut-off, and low angle drift of center wavelength. For example, combining the high absorption of high refractive index Si:H in the visible light region and the characteristics of high refractive index and low absorption in the near-infrared band from 780nm to 1100nm to manufacture corresponding filters.

However, the average reflectivity of the existing near-infrared narrowband filters in the visible region is greater than 25%, even in some bands, as high as 90% or more, so that the filters appears red (magenta, deep red, purple red, etc.) or green (dark green). The intensity of the reflected light of the filter is high, and the brightness of the reflection color is high. However, the under-screen devices in the full screen of mobile phones and on-board devices require filters with diversified reflection colors, low reflection energy intensity, and low reflection color brightness in specific applications.

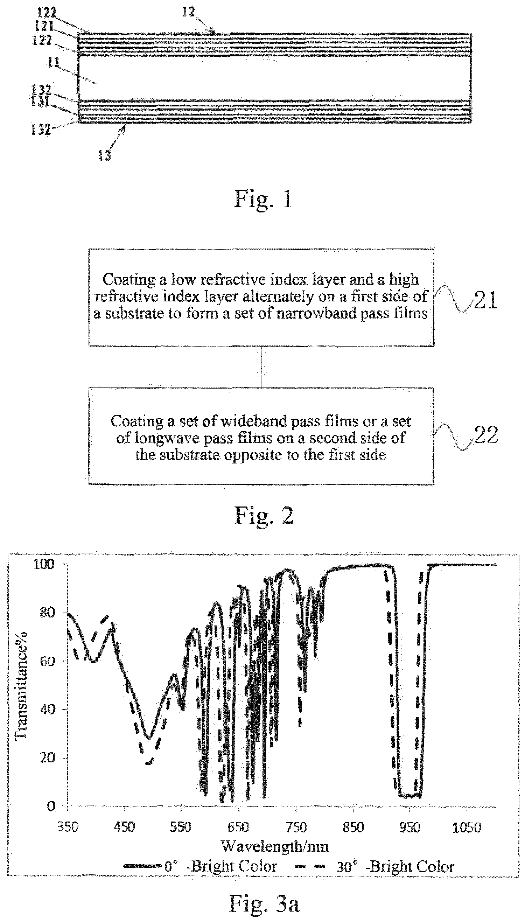

In order to meet the application requirements of the above-mentioned mobile phone terminals or on-board terminals for filter, an example of the present disclosure provides a near-infrared narrowband filter. FIG. 1 is a schematic structural view of the near-infrared narrowband filter provided by an example of the present disclosure. As shown in FIG. 1, the near-infrared narrowband filter includes:
a substrate 11; a set of narrowband pass films 12 disposed on a first side of the substrate 11; and a set of wideband pass films or a set of longwave pass films 13. The set of wideband pass films or the set of longwave pass films 13 is disposed on a second side of the substrate opposite to the first side. The passband of the set of wideband pass films or the set of longwave pass films 13 is wider than that of the set of narrowband pass films 12. The set of narrowband pass films 12 includes a high refractive index layer having a refractive index greater than 3 and a low refractive index layer having the refractive index less than 3 within a wavelength range of 780 nm to 3000 nm. In a CIE xyz coordinate system, a reflection color of the near-infrared narrowband filter satisfies: x < 0.509; y < 0.363; and z < 50%.

Specifically, the near-infrared narrowband filter provided by an example of the present disclosure provided with a set of narrowband pass films on a first side of the substrate, and a set of wideband pass films on a second side of the substrate. The set of narrowband pass films has a high refractive index layer 121 having a refractive index greater than 3 and a low refractive index layer 122 having a refractive index less than 3 within a wavelength range of 780 nm to 3000 nm. The set of wideband pass films has a high refractive index layer 131 or a high refractive index germanium-based layer 131 having a refractive index greater than 3 and a low refractive index layer 132 having a refractive index less than 3 within a wavelength range of 780 nm to 3000 nm. The above-mentioned near-infrared narrowband filter having the set of narrowband pass films and the set of wideband pass films satisfies the dark reflection color conditions of z < 50% and x < 0.509 and y < 0.363. Thereby, a near-infrared narrowband filter with diversified reflection color, low reflection energy intensity, and low reflection color brightness that meets the application requirements of mobile phone terminals or on-board terminals is obtained.

On the basis of the above example, the set of narrowband pass films in the near-infrared narrowband filter provided by an example of the present disclosure may further include a middle refractive index layer. The refractive index of the middle refractive index layer is between the refractive index of the high refractive index layer and the refractive index of the low refractive index layer, so that the set of narrowband pass films of the near-infrared narrowband filter may have three refractive layers with different refractive indexes. Thereby, a near-infrared narrowband filter having diversified reflection color, low reflection energy intensity, and low reflection color brightness is obtained to meet the application requirements of under-screen devices in the full screen of mobile phones and on-board devices.

On the basis of the above example, the high refractive index layer in the near-infrared narrowband filter provided by an example of the present disclosure is formed by one or more of hydrogenated silicon, SiₓGe₁₋ₓ and SiₓGe₁₋ₓ: H, or the high refractive index germanium-based layer is formed by one or more of hydrogenated germanium, SiₓGe₁₋ₓ, and SiₓGe₁₋ₓ: H. That is, when forming the set of films with a high refractive index layer in the near-infrared narrowband filter provided by an example of the present disclosure, one or more of hydrogenated silicon, SiₓGe₁₋ₓ and SiₓGe₁₋ₓ:H may be mixed and coated to form the high refractive index layer; when forming a set of films with a high refractive index germanium-based layer, one or more of germanium hydride, SiₓGe₁₋ₓ and SiₓGe₁₋ₓ: H are mixed and coated to form the high refractive index germanium-based layer.

On the basis of the above example, the low refractive index layer in the near-infrared narrowband filter provided by an example of the present disclosure is formed by one or more of SiO₂, Si₃N₄, SiOₓN_{y}, Ta₂O₅, Nb₂O₅, TiO₂, Al₂O₃, SiCN and SiC. That is, one or more of SiO₂, Si₃N₄, SiOₓN_{y}, Ta₂O₅, Nb₂O₅, TiO₂, Al₂O₃, SiCN and SiC may be mixed and coated to form the low refractive index layers of the two set of films of the near-infrared narrowband filter provided by an example of the present disclosure.

On the basis of the above example, the near-infrared narrowband filter provided by an example of the present disclosure further includes a plurality of matching layers with a refractive index ranging from 1.7 to 4.5 in the wavelength range of 780 nm to 3000 nm. That is, the near-infrared narrowband filter provided by an example of the present disclosure further includes a plurality of matching layers.

On the basis of the above example, the middle refractive index layer in the near-infrared narrowband filter provided by an example of the present disclosure is formed by one or more of a-SiOₓ:H_{y}, a-SiNₓ:H_{y}, a-GeOₓ:H_{y}, a-GeNₓ:H_{y}, a-Si_{z}Ge_{1-z}Oₓ:H_{y} and a-Si_{z}Ge_{1-z}Nₓ: H_{y.} That is, one or more of a-SiOₓ:H_{y}, a-SiNₓ:H_{y}, a-GeOₓ:H_{y}, a-GeNₓ:H_{y}, a-Si_{z}Ge_{1-z}Oₓ:H_{y} and a-Si_{z}Ge_{1-z}Nₓ:H_{y} may be mixed and coated to form the middle refractive index layer of the near-infrared narrowband filter provided by an example of the present disclosure.

In the near-infrared narrowband filter provided by an example of the present disclosure, after the set of narrowband pass films and the set of wideband pass films or the set of longband pass films are coated on both sides, the reflection color of the near-infrared narrowband filter may satisfy: x < 0.509; y < 0.363; and z < 30% in the CIE xyz coordinate system. That is, in the near-infrared narrowband filter provided by an example of the present disclosure, after the set of narrowband pass films and set of wideband pass films are coated on both sides, the reflection color in the near-infrared narrowband filter satisfies the reflection conditions in the CIE xyz coordinate system: x < 0.509; y < 0.363; and z < 30%. Thereby, a near-infrared narrowband filter having diversified reflection color, low reflection energy intensity, and low reflection color brightness is obtained to meet the application requirements of under-screen devices in the full screen of mobile phones and on-board devices.

On the basis of the above example, in the near-infrared narrowband filter provided by an example of the present disclosure, when the incident light enters the near-infrared narrowband filter at an angle of 0° to 30°, the center wavelength drift of the passband of the set of narrowband pass films is below 16 nm, that is, the center wavelength drift amplitude of the passband waveband is less than 16 nm. That is, when the near-infrared narrowband filter provided by an example of the present disclosure is in use, the incident light enters the near-infrared narrowband filter at an angle of 0° to 30°, and the center wavelength shift of the passband of the set of narrowband pass films is below 16 nm, so as to obtain a near-infrared narrowband filter with better coating performance.

On the basis of the above example, the center wavelength drifts of *p* light and *s* light of the near-infrared narrowband filter provided by an example of the present disclosure are below 5 nm. That is, when the near-infrared narrowband filter provided by the example of the present disclosure is in use, the center wavelength drifts of *p* light and *s* light are below 5 nm, so as to obtain a near-infrared narrowband filter with better coating performance.

On the basis of the above example, the total thickness of the set of narrowband pass films and the set of wideband pass films of the near-infrared narrowband filter provided by an example of the present disclosure is less than 15 µm. That is, in the near-infrared narrowband filter provided by an example of the present disclosure, after the sets of films are coated on both sides, the total thickness of the set of narrowband pass films and the set of wideband pass films is less than 15 µm, making the near-infrared narrowband filter thinner and easy to use.

An example of the present disclosure also provides a manufacturing method of the near-infrared narrowband filter. FIG. 2 is a flowchart of the manufacturing method of the near-infrared narrowband filter provided by an example of the present disclosure. As shown in FIG. 2, the method includes:
Step 21) coating alternately a low refractive index layer and a high refractive index layer on a first side of the substrate to form a set of narrowband pass films, and
Step 22) coating a set of wideband pass films or a set of longwave pass films on a second side of the substrate opposite to the first side, wherein the passband of the set of wideband pass films or the set of longwave pass films is wider than that of the set of narrowband pass films, the set of narrowband pass films includes a high refractive index layer having a refractive index greater than 3 and a low refractive index layer having the refractive index less than 3 within a wavelength range of 780 nm to 3000 nm, and in a CIE xyz coordinate system, a reflection color of the near-infrared narrowband filter satisfies: x < 0.509; y < 0.363; and z < 50%.

In the manufacturing method of the near-infrared narrowband filter provided by an example of the present disclosure, by coating the set of narrowband pass films and the set of wideband pass films with the high refractive index layer having the refractive index greater than 3 and the low refractive index layer having the refractive index less than 3 within the wavelength range of 780 nm to 3000 nm on both sides of the substrate respectively, the near-infrared narrowband filter with the reflection color that satisfies the dark reflection color condition z < 50% and x < 0.509 and y < 0.363 in the CIE xyz coordinate system is obtained to meet the application requirements of the under-screen devices in the full screen of mobile phones and on-board devices for the diversified reflection color, low reflection energy intensity, and low reflection color brightness of the near-infrared narrowband filter.

On the basis of the above example, the manufacturing method of the near-infrared narrowband filter provided by an example of the present disclosure further includes: coating the high refractive index layer and the low refractive index layer on both sides of the substrate by sputtering coating or evaporation coating. That is, the manufacturing method of the near-infrared narrowband filter provided by an example of the present disclosure may adopt coating process of sputtering coating or evaporation coating when coating the substrate. The high refractive index layer or the low refractive index layer is respectively coated on both sides of the substrate, and the corresponding sets of films are formed. The method is simple, the operation is convenient, and the coating is accurate.

On the basis of the above example, the manufacturing method of the near-infrared narrowband filter provided by an example of the present disclosure further includes: coating a middle refractive index layer on one side of the set of narrowband pass films, wherein the refractive index of the middle refractive index layer is between the refractive index of the high refractive index layer and the refractive index of the low refractive index layer. That is, when coating the substrate using the manufacturing method of the near-infrared narrowband filter provided by an example of the present disclosure, the above-mentioned two-layer film materials (high refractive index layer and low refractive index layer) may be used for coating to obtain the set of narrowband pass films and the set of wideband pass films or the set of longwave pass films. Alternatively, three-layer film materials, namely high refractive index layer, middle refractive index layer and low refractive index layer, may be used to form the set of wideband pass films or the set of longwave pass films. The method is flexible in operation and precise in coating.

On the basis of the above example, the manufacturing method of the near-infrared narrowband filter provided by an example of the present disclosure further includes: bombarding the target with a charged ion beam obtained by glow discharge based on silicon, germanium, argon, hydrogen, and oxygen to coat the middle refractive index layer, the middle refractive index layer including one or more of a-SiOₓ:H_{y}, a-SiNₓ:H_{y}, a-GeOₓ:H_{y}, a-GeNₓ:H_{y}, a-Si_{z}Ge_{1-z}Oₓ:H_{y} and a-Si_{z}Ge_{1-z}Nₓ:H_{y}. That is, before the glow discharge, vacuum the deposition chamber to less than 5^{∗}10^-5torr. During the glow discharge deposition process, argon gas with a flow rate of 10 seem to 300 sccm is used as the reaction gas, and hydrogen gas with a flow rate of less than 80 seem and oxygen gas with a flow rate of less than 60 sccm are sequentially introduced. During the hydrogenation reaction, oxygen atoms are doped into the amorphous silicon film to form new bonds with Si in the amorphous silicon to form hydrogenated amorphous silicon oxide (a-SiOₓ:H_{y}), hydrogenated amorphous germanium oxide (a-GeOₓ:H_{y}) and hydrogenated amorphous silicon germanium oxide (a-Si_{z}Ge_{1-z}Oₓ:H_{y}), thereby obtaining the corresponding substance for coating the middle refractive index layer.

In order to better illustrate the coating structure of the near-infrared narrowband filter film sets in the present disclosure, the following examples are now provided for further description.

### Example 1

A second side of a near-infrared narrowband filter provided by an example of the present disclosure may be coated with a set of wideband pass films or a set of longband pass films. Table 1a is a table showing the layer thicknesses of the films in the set of wideband pass films or the set of longband pass films. Table 1a reflects the layer structure of the set of wideband pass films or the set of longband pass films of the near-infrared narrowband filter of the present disclosure. Two film materials are alternately coated with different thicknesses to form a required film set structure. In the structure shown in Table 1a, SiO₂ is a low refractive index dielectric material, and Si:H is a high refractive index silicon-based material.

When a first side of the near-infrared narrowband filter is coated with a set of bright reflection color, narrowband pass films, a structure shown in Table 1b below may be referred to. Table 1b is a table showing the layer thicknesses of the films in the set of bright reflection color, narrowband pass films, and this table reflects the layer structure of the set of bright reflection color, narrowband pass films of the set of narrowband pass films of the near-infrared narrowband filter of the present disclosure. Also, two film materials are alternately coated with different thicknesses to form a corresponding film set structure, wherein a high refractive index silicon-based material is a-Si:H, and a low refractive index dielectric material is SiO₂. According to a 1931 CIE xyz system characterization, the double-sided coating filters prepared based on Table 1a and Table 1b are characterized as (0.351, 0.324, 53.03%) and (0.356, 0.315, 49.09%) when the incident light is incident at an angle of 0° and 30°, respectively, where *x* and *y* represent the chromaticity coordinates of the color, and z represents the brightness of the color. FIG. 3a is a diagram showing a relationship between reflectivity and wavelength of a filter coated with the set of bright reflection color, narrowband pass films provided in example 1 of the present disclosure.

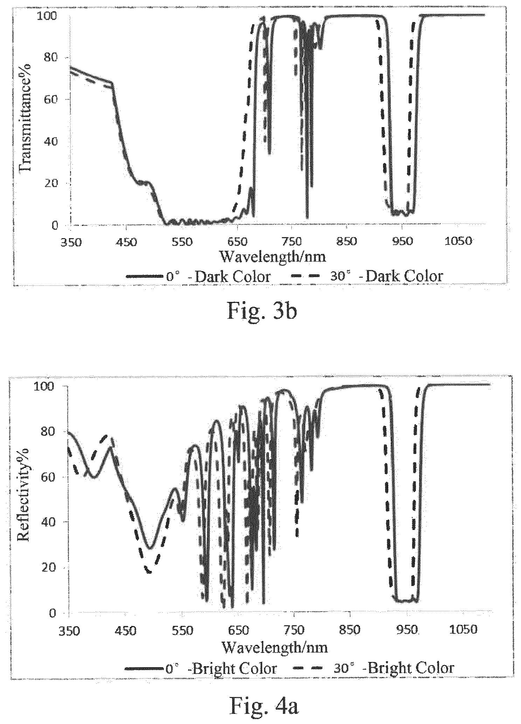

When a first side of the near-infrared narrowband filter is coated with a set of dark reflection color, narrowband pass films, a structure shown in Table 1c below may be referred to. Table 1c is a table showing the layer thickness of the films in the set of dark reflection color, narrowband pass films, and this table reflects the layer structure of the set of dark reflection color, narrowband pass films of the set of narrowband pass films of the near-infrared narrowband filter of the present disclosure. Three kinds of film materials are coated with different thicknesses to form a corresponding films set structure. In Table 1c, the three film materials are: high refractive index material a-Si:H; low refractive index material SiO₂; and middle refractive index material a-SiOₓ:H_{y}. According to a 1931 CIE xyz system characterization, the double-sided coating filters prepared based on Table 1a and Table 1c are characterized as (0.192, 0.077, 3.8%) and (0.216, 0.08, 3.9%) when the incident light is incident at an angle of 0° and 30°, respectively, where *x* and *y* represent the chromaticity coordinates of the color, and z represents the brightness of the color. FIG. 3b is a diagram showing a relationship between reflectivity and wavelength of a filter coated with the set of dark reflection color, narrowband pass films provided in example 1 of the present disclosure.

**Table 1a: Layer thickness of film in a set of wideband pass films or a set of longband pass films, unit: nm**

| Layer number | 1 | 2 | 3 | 4 | 5 6 | |
|---|---|---|---|---|---|---|
| Material | SiO₂ | Si:H | SiO₂ | Si:H | SiO₂ | Si:H |
| Thickness | 170.6 | 27.72 | 82.96 | 32.7 | 132.4 | 40.69 |
| Layer number | 6 | 7 | 8 | 9 | 10 | 11 |
| Material | SiO₂ | Si:H | SiO₂ | Si:H | SiO₂ | Si:H |
| Thickness | 101.55 | 31.19 | 119.83 | 37.6 | 122.7 | 34.77 |
| Layer number | 12 | 13 | 14 | 15 | 16 | 17 |
| Materi al | SiO₂ | Si:H | SiO₂ | Si:H | SiO₂ | Si:H |
| Thickness | 116.51 | 34.77 | 118.47 | 30.3 | 127.7 | 42.24 |
| Layer number | 18 | 19 | 20 | 21 | 22 | 23 |
| Material | SiO₂ | Si:H | SiO₂ | Si:H | SiO₂ | Si:H |
| Thickness | 123.15 | 26.47 | 105.93 | 42.1 | 126.9 | 35.13 |
| Layer number | 24 | 25 | 26 | - | - | - |
| Material | SiO₂ | Si:H | SiO₂ | - | - | - |
| Thickness | 74.04 | 22.29 | 94.59 | - | - | - |

**Table 1b: Layer thickness of film in a set of bright reflection color, narrowband pass films, unit: nm**

| Layer number | 1 | 2 | 3 | 4 | 5 |
|---|---|---|---|---|---|
| Material | a-Si:H | SiO₂ | a-Si:H | SiO₂ | a-Si:H |
| Thickness | 148.86 | 385.37 | 60.57 | 498.56 | 133.63 |
| Layer number | 6 | 7 | 8 | 9 | 10 |
| Material | SiO₂ | a-Si:H | SiO₂ | a-Si:H | SiO₂ |
| Thickness | 148.47 | 58.19 | 146.02 | 389.75 | 168.05 |
| Layer number | 11 | 12 | 13 | 14 | 15 |
| Material | a-Si:H | SiO₂ | a-Si:H | SiO₂ | a-Si:H |
| Thickness | 77.19 | 107.45 | 399.35 | 116.46 | 83.12 |
| Layer number | 16 | 17 | 18 | 19 | 20 |
| Material | SiO₂ | a-Si:H | SiO₂ | a-Si:H | SiO₂ |
| Thickness | 125.35 | 404.06 | 54.76 | 98.94 | 130.29 |
| Layer number | 21 | 22 | 23 | 24 | |
| Material | a-Si:H | SiO₂ | a-Si:H | SiO₂ | |
| Thickness | 501.89 | 230.75 | 100.12 | 459.47 | |

**Table 1c: Layer thickness of film in a set of dark reflection color, narrowband pass films, unit: nm**

| Layer number | 1 | 2 | 3 | 4 | 5 |
|---|---|---|---|---|---|
| Material | a-Si:H | SiO₂ | a-Si:H | SiO₂ | a-SiOₓ:H_{y} |
| Thickness | 158.5 | 372.09 | 66.79 | 397.77 | 142.05 |
| Layer number | 6 | 7 | 8 | 9 | 10 |
| Material | SiO₂ | a-Si:H | SiO₂ | a-SiOₓ:H_{y} | SiO₂ |
| Thickness | 427.94 | 4.81 | 226.16 | 387.64 | 179.16 |
| Layer number | 11 | 12 | 13 | 14 | 15 |
| Material | a-Si:H | SiO₂ | a-Si:H | SiO₂ | a-Si:H |
| Thickness | 78.18 | 52.78 | 408.53 | 143.7 | 79.69 |
| Layer number | 16 | 17 | 18 | 19 | 20 |
| Material | SiO₂ | a-Si:H | SiO₂ | a-Si:H | SiO₂ |
| Thickness | 93.16 | 415.52 | 54.15 | 77.91 | 191.01 |
| Layer number | 21 | 22 | 23 | 24 | 25 |
| Material | a-Si:H | SiO₂ | a-Si:H | a-SiOₓ:H_{y} | SiO₂ |
| Thickness | 512.57 | 211.45 | 144.32 | 69.51 | 548.39 |

### Example 2

A second side of a near-infrared narrowband filter provided by an example of the present disclosure may be coated with a set of wideband pass films or a set of longband pass films. Table 2a is a table showing the layer thicknesses of the films in the set of wideband pass films or the set of longband pass films, and this table reflects the layer structure of the set of wideband pass films or the set of longband pass films of the near-infrared narrowband filter of the present disclosure. Two film materials are alternately coated with different thicknesses to form a required film set structure. In the structure shown in Table 2a, SiO₂ is a low refractive index dielectric material, and TiO₂ is a high refractive index material.

When a first side of the near-infrared narrowband filter is coated with a set of bright reflection color, narrowband pass films, a structure shown in Table 2b below may be referred to. Table 2b is a table showing the layer thicknesses of the films in the set of bright reflection color, narrowband pass films, and this table reflects the layer structure of the set of bright reflection color, narrowband pass films of the set of narrowband pass films of the near-infrared narrowband filter of the present disclosure. Also, two film materials are alternately coated with different thicknesses to form a corresponding film set structure, wherein a high refractive index silicon-based material is a-Si:H, and a low refractive index dielectric material is SiO₂. According to a 1931 CIE xyz system characterization, the double-sided coating filters prepared based on Table 2a and Table 2b are characterized as (0.351, 0.324, 53.03%) and (0.356, 0.315, 49.09%) when the incident light is incident at an angle of 0° and 30°, respectively, where *x* and *y* represent the chromaticity coordinates of the color, and z represents the brightness of the color. FIG. 4a is a diagram showing a relationship between reflectivity and wavelength of a filter coated with the set of bright reflection color, narrowband pass films provided in example 2 of the present disclosure.

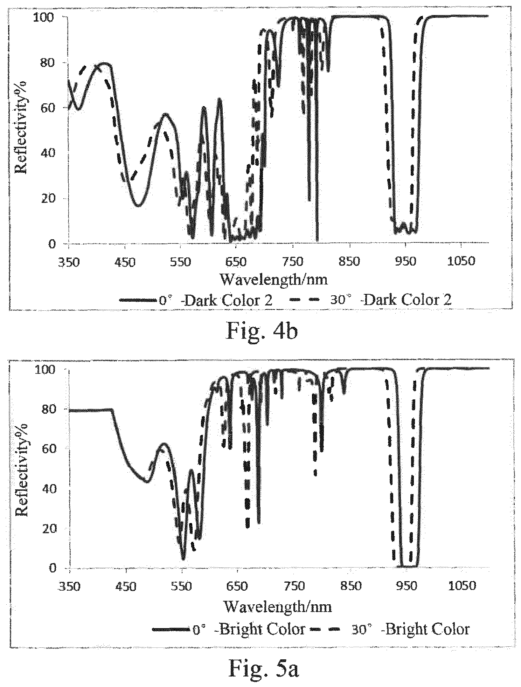

When a first side of the near-infrared narrowband filter is coated with a set of dark reflection color, narrowband pass films, a structure shown in Table 2c below may be referred to. Table 2c is a table showing the layer thickness of the films in the set of dark reflection color, narrowband pass films, and this table reflects the layer structure of the set of dark reflection color, narrowband films of the set of narrowband pass films of the near-infrared narrowband filter of the present disclosure. Also, two film materials are alternately coated with different thicknesses to form a corresponding film set structure, wherein a high refractive index silicon-based material is a-Si:H, and a low refractive index dielectric material is SiO₂. According to a 1931 CIE xyz system characterization, the double-sided coating filters prepared based on Table 2a and Table 2c are characterized as (0.301, 0.319, 35.22%) and (0.276, 0.309, 29.66%) when the incident light is incident at an angle of 0° and 30°, respectively, where x and *y* represent the chromaticity coordinates of the color, and z represents the brightness of the color. FIG. 4b is a diagram showing a relationship between reflectivity and wavelength of a filter coated with the set of dark reflection color, narrowband pass films provided in example 2 of the present disclosure.

**Table 2a: Layer thickness of film in a set of wideband pass films or a set of longband pass films, unit: nm**

| Layer number | 1 | 2 | 3 | 4 | 5 | 6 |
|---|---|---|---|---|---|---|
| Material | SiO₂ | TiO₂ | SiO₂ | TiO₂ | SiO₂ | TiO₂ |
| Thickness | 134.4 | 72.6 | 90.3 | 67.45 | 120.98 | 77.91 |
| Layer number | 7 | 8 | 9 | 10 | 11 | 12 |
| Material | SiO₂ | TiO₂ | SiO₂ | TiO₂ | SiO₂ | TiO₂ |
| Thickness | 136 | 83.4 | 97.5 | 70.9 | 270.45 | 75.64 |
| Layer number | 13 | 14 | 15 | 16 | 17 | 18 |
| Material | SiO₂ | TiO₂ | SiO₂ | TiO₂ | SiO₂ | TiO₂ |
| Thickness | 111.7 | 67.6 | 101.7 | 197.77 | 116.51 | 74.86 |
| Layer number | 19 | 20 | 21 | 22 | 23 | 24 |
| Material | SiO₂ | TiO₂ | SiO₂ | TiO₂ | SiO₂ | TiO₂ |
| Thickness | 118.7 | 75.8 | 120.1 | 76.□6 | 103.28 | 42.14 |
| Layer number | 25 | 2 | 27 | 28 | 29 | 30 |
| Material | SiO₂ | TiO₂ | SiO₂ | TiO₂ | SiO₂ | TiO₂ |
| Thickness | 133.6 | 83.1 | 131.4 | 83.54 | 133.68 | 85.88 |
| Layer number | 31 | 32 | 33 | 34 | 35 | 36 |
| Material | SiO₂ | TiO₂ | SiO₂ | TiO₂ | SiO₂ | TiO₂ |
| Thickness | 133.1 | 84.1 | 135.3 | 84.91 | 135.75 | 84.61 |
| Layer number | 37 | 38 | 39 | 40 | 41 | 42 |
| Material | SiO₂ | TiO₂ | SiO₂ | TiO₂ | SiO₂ | TiO₂ |
| Thickness | 87.1 | 75.6 | 124.5 | 80.29 | 129.71 | 82.58 |
| Layer number | 43 | 44 | 45 | 46 | 47 | - |
| Material | SiO₂ | TiO₂ | SiO₂ | TiO₂ | SiO₂ | - |
| Thickness | 136.4 | 87.5 | 130.1 | 77.82 | 103.24 | - |

**Table 2b: Layer thickness of film in a set of bright reflection color, narrowband pass films, unit: nm**

| Layer number | 1 | 2 | 3 | 4 | 5 |
|---|---|---|---|---|---|
| Material | a-Si:H | SiO₂ | a-Si:H | SiO₂ | a-Si:H |
| Thickness | 148.86 | 385.37 | 60.57 | 498.56 | 133.63 |
| Layer number | 6 | 7 | 8 | 9 | 10 |
| Material | SiO₂ | a-Si:H | SiO₂ | a-Si:H | SiO₂ |
| Thickness | 148.47 | 58.19 | 146.02 | 389.75 | 168.05 |
| Layer number | 11 | 12 | 13 | 14 | 15 |
| Material | a-Si:H | SiO₂ | a-Si:H | SiO₂ | a-Si:H |
| Thickness | 77.19 | 107.45 | 399.35 | 116.46 | 83.12 |
| Layer number | 16 | 17 | 18 | 19 | 20 |
| Material | SiO₂ | a-Si:H | SiO₂ | a-Si:H | SiO₂ |
| Thickness | 125.35 | 404.06 | 54.76 | 98.94 | 130.29 |
| Layer number | 21 | 22 | 23 | 24 | |
| Material | a-Si:H | SiO₂ | a-Si:H | SiO₂ | |
| Thickness | 501.89 | 230.75 | 100.12 | 459.47 | |

**Table 2c: Layer thickness of film in a set of dark reflection color, narrowband pass films, unit: nm**

| Layer number | 1 | 2 | 3 | 4 | 5 |
|---|---|---|---|---|---|
| Material | a-Si:H | SiO₂ | a-Si:H | SiO₂ | a-Si:H |
| Thickness | 149.59 | 386.15 | 55.34 | 523.36 | 133.76 |
| Layer number | 6 | 7 | 8 | 9 | 10 |
| Material | SiO₂ | a-Si:H | SiO₂ | a-Si:H | SiO₂ |
| Thickness | 114.26 | 71.4 | 170.76 | 395.02 | 104.98 |
| Layer number | 11 | 12 | 13 | 14 | 15 |
| Material | a-Si:H | SiO₂ | a-Si:H | SiO₂ | a-Si:H |
| Thickness | 68.05 | 166.6 | 397.26 | 100.06 | 70.54 |
| Layer number | 16 | 17 | 18 | 19 | 20 |
| Material | SiO₂ | a-Si:H | SiO₂ | a-Si:H | SiO₂ |
| Thickness | 148.01 | 413.09 | 47.19 | 73.44 | 170.98 |
| Layer number | 21 | 22 | 23 | 24 | 25 |
| Material | a-Si:H | SiO₂ | a-Si:H | SiO₂ | - |
| Thickness | 514.17 | 197.5 | 127.25 | 475.28 | - |

### Example 3

A second side of a near-infrared narrowband filter provided by an example of the present disclosure may be coated with a set of wideband pass films or a set of longband pass films. Table 3a is a table showing the layer thicknesses of the films in the set of wideband pass films or the set of longband pass films, and this table reflects the layer structure of the set of wideband pass films or the set of longband pass films of the near-infrared narrowband filter of the present disclosure. Two film materials are alternately coated with different thicknesses to form a required film set structure. In the structure shown in Table 1a, SiO₂ is a low refractive index dielectric material, and Si:H is a high refractive index silicon-based material.

When a first side of the near-infrared narrowband filter is coated with a set of bright reflection color, narrowband pass films, a structure shown in Table 3b below may be referred to. Table 3b is a table showing the layer thicknesses of the films in the set of bright reflection color, narrowband pass films, and this table reflects the layer structure of the set of bright reflection color, narrowband pass films of the set of narrowband pass films of the near-infrared narrowband filter of the present disclosure. Also, two film materials are alternately coated with different thicknesses to form a corresponding film set structure, wherein a high refractive index silicon-based material is a-Si:H, and a low refractive index dielectric material is SiO₂. According to a 1931 CIE xyz system characterization, the double-sided coating filters prepared based on Table 3a and Table 3b are characterized as (0.366, 0.292, 49.80%) and (0.372, 0.288, 49.47%) when the incident light is incident at an angle of 0° and 30°, respectively, where *x* and *y* represent the chromaticity coordinates of the color, and z represents the brightness of the color. FIG. 5a is a diagram showing a relationship between reflectivity and wavelength of a filter coated with the set of bright reflection color, narrowband pass films provided in example 3 of the present disclosure.

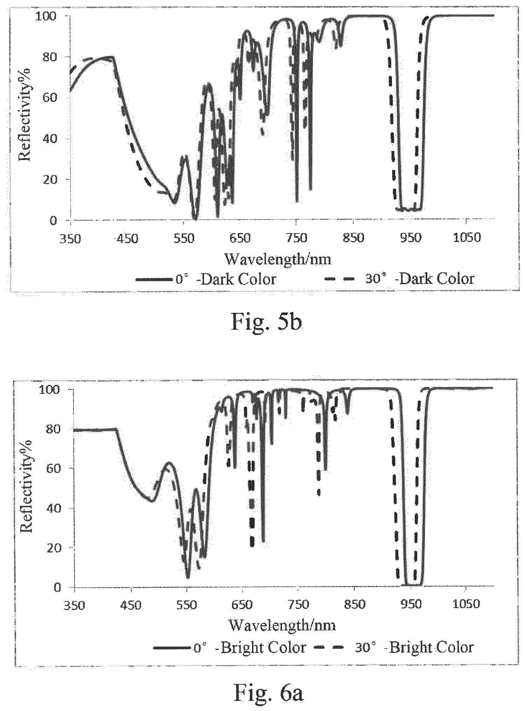

When a first side of the near-infrared narrowband filter is coated with a set of dark reflection color, narrowband pass films, a structure shown in Table 3c below may be referred to. Table 3c is a table showing the layer thickness of the films in the set of dark reflection color, narrowband pass films, and this table reflects the layer structure of the set of dark reflection color, narrowband films of the set of narrowband pass films of the near-infrared narrowband filter of the present disclosure. Two kinds of film materials are coated with different thicknesses to form a corresponding film set structure, wherein the two film materials are Ge:H, a high refractive index germanium-based material, and SiO₂, a low refractive index dielectric material. According to a 1931 CIE xyz system characterization, the double-sided coating filters prepared based on Table 3a and Table 3c are characterized as (0.339, 0.226, 26.65%) and (0.361, 0.246, 28.07%) when the incident light is incident at an angle of 0° and 30°, respectively, where x and y represent the chromaticity coordinates of the color, and z represents the brightness of the color. FIG. 5b is a diagram showing a relationship between reflectivity and wavelength of a filter coated with the set of dark reflection color, narrowband pass films provided in example 3 of the present disclosure.

**Table 3a: Layer thickness of film in a set of wideband pass films or a set of longband pass films, unit: nm**

| Layer number | 1 | 2 | 3 | 4 | 5 | 6 |
|---|---|---|---|---|---|---|
| Material | SiO₂ | Si:H | SiO₂ | Si:H | SiO₂ | Si:H |
| Thickness | 32.42 | 27.09 | 92.93 | 37.22 | 83.78 | 75.25 |
| Layer number | 7 | 8 | 9 | 10 | 11 | 12 |
| Material | SiO₂ | Si:H | SiO₂ | Si:H | SiO₂ | Si:H |
| Thickness | 85.01 | 45.84 | 60 | 55.06 | 125.72 | 76.15 |
| Layer number | 13 | 14 | 15 | 16 | 17 | 18 |
| Material | SiO₂ | Si:H | SiO₂ | Si:H | SiO₂ | Si:H |
| Thickness | 60.96 | 45.69 | 63.42 | 65.25 | 117.06 | 72.66 |
| Layer number | 19 | 20 | 21 | 22 | 23 | 24 |
| Material | SiO₂ | Si:H | SiO₂ | Si:H | SiO₂ | Si:H |
| Thickness | 61.09 | 45.85 | 61.81 | 71.56 | 107.26 | 71.04 |
| Layer number | 25 | 26 | 27 | 28 | 29 | 30 |
| Material | SiO₂ | Si:H | SiO₂ | Si:H | SiO₂ | Si:H |
| Thickness | 61.87 | 47.55 | 52.23 | 73.93 | 131.17 | 69.77 |
| Layer number | 31 | 32 | 33 | 34 | 35 | - |
| Material | SiO₂ | Si:H | SiO₂ | Si:H | SiO₂ | - |
| Thickness | 50.78 | 37.72 | 89.25 | 89.18 | 93.91 | - |

**Table 3b: Layer thickness of film in a set of bright reflection color, narrowband pass films, unit: nm**

| Layer number | 1 | 2 | 3 | 4 | 5 |
|---|---|---|---|---|---|
| Material | SiO₂ | a-Si:H | SiO₂ | a-Si:H | SiO₂ |
| Thickness | 271.34 | 103.33 | 313.14 | 52.95 | 423.24 |
| Layer number | 6 | 7 | 8 | 9 | 10 |
| Material | a-Si:H | SiO₂ | a-Si:H | SiO₂ | a-Si:H |
| Thickness | 161.06 | 359.67 | 121.13 | 325.95 | 229.85 |
| Layer number | 11 | 12 | 13 | 14 | 15 |
| Material | SiO₂ | a-Si:H | SiO₂ | a-Si:H | SiO₂ |
| Thickness | 67.6 | 120.61 | 230.7 | 71.12 | 153.94 |
| Layer number | 16 | 17 | 18 | 19 | 20 |
| Material | a-Si:H | SiO₂ | a-Si:H | SiO₂ | a-Si:H |
| Thickness | 269.59 | 51.55 | 106 | 116.26 | 62.54 |
| Layer number | 21 | 22 | 23 | 24 | 25 |
| Material | SiO₂ | a-Si:H | SiO₂ | a-Si:H | SiO₂ |
| Thickness | 161.77 | 261.54 | 131.1 | 99.22 | 74.22 |
| Layer number | 26 | 27 | 28 | 29 | 30 |
| Material | a-Si:H | SiO₂ | a-Si:H | SiO₂ | a-Si:H |
| Thickness | 104.2 | 108.34 | 259.53 | 220.66 | 30.75 |
| Layer number | 31 | 32 | 33 | 34 | 35 |
| Material | SiO₂ | a-Si:H | SiO₂ | a-Si:H | SiO₂ |
| Thickness | 117.28 | 7.85 | 146.55 | 165.16 | 72.64 |
| Layer number | 36 | 37 | 38 | 39 | 40 |
| Material | a-Si:H | SiO₂ | a-Si:H | SiO₂ | a-Si:H |
| Thickness | 32.5 | 248 | 131.47 | 319.05 | 129.39 |

**Table 3c: Layer thickness of film in a set of dark reflection color, narrowband pass films, unit: nm**

| Layer number | 1 2 | | 3 | 4 | 5 |
|---|---|---|---|---|---|
| Material | Ge:H | SiO₂ | Ge:H | SiO₂ | Ge:H |
| Thickness | 94.5 | 66.27 | 146.33 | 112.37 | 84.16 |
| Layer number | 6 | 7 | 8 | 9 | 10 |
| Material | SiO₂ | Ge:H | SiO₂ | Ge:H | SiO₂ |
| Thickness | 126.13 | 105.98 | 20.95 | 282.78 | 114.81 |
| Layer number | 11 | 12 | 13 | 14 | 15 |
| Material | Ge:H | SiO₂ | Ge:H | SiO₂ | Ge:H |
| Thickness | 79.45 | 137.63 | 404.19 | 53.8 | 226.65 |
| Layer number | 16 | 17 | 18 | - | - |
| Material | SiO₂ | Ge:H | SiO₂ | - | - |
| Thickness | 126.6 | 524.32 | 274.33 | - | - |

### Example 4

A second side of a near-infrared narrowband filter provided by an example of the present disclosure may be coated with a set of wideband pass films or a set of longband pass films. Table 4a is a table showing the layer thicknesses of the films in the set of wideband pass films or the set of longband pass films, and this table reflects the layer structure of the set of wideband pass films or the set of longband pass films of the near-infrared narrowband filter of the present disclosure. Two film materials are alternately coated with different thicknesses to form a required film set structure. In the structure shown in Table 4a, SiO₂ is a low refractive index material, and Si:H is a high refractive index material.

When a first side of the near-infrared narrowband filter is coated with a set of bright reflection color, narrowband pass films, a structure shown in Table 4b below may be referred to. Table 4b is a table showing the layer thicknesses of the films in the set of bright reflection color, narrowband pass films, and this table reflects the layer structure of the set of bright reflection color, narrowband pass films of the set of narrowband pass films of the near-infrared narrowband filter of the present disclosure. Also, two film materials are alternately coated with different thicknesses to form a corresponding film set structure, wherein a high refractive index silicon-based material is a-Si:H, and a low refractive index dielectric material is SiO₂. According to a 1931 CIE xyz system characterization, the double-sided coating filters prepared based on Table 4a and Table 4b are characterized as (0.366, 0.292, 49.80%) and (0.372, 0.288, 49.47%) when the incident light is incident at an angle of 0° and 30°, respectively, where *x* and *y* represent the chromaticity coordinates of the color, and *z* represents the brightness of the color. FIG. 6a is a diagram showing a relationship between reflectivity and wavelength of a filter coated with the set of bright reflection color, narrowband pass films provided in example 4 of the present disclosure.

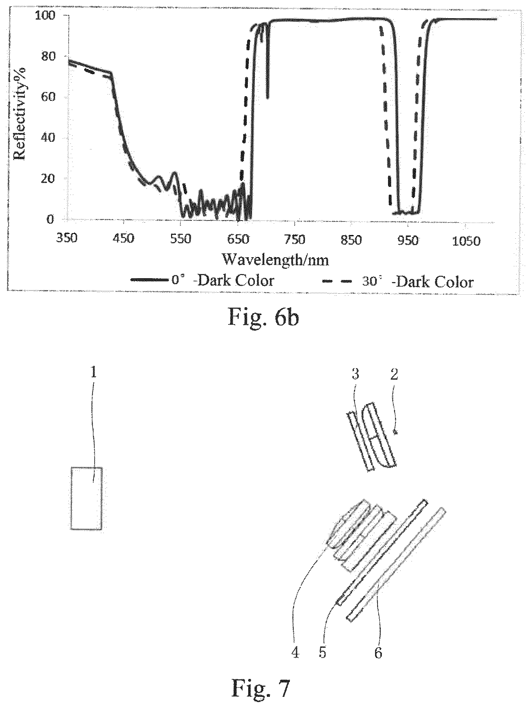

When a first side of the near-infrared narrowband filter is coated with a set of dark reflection color, narrowband pass films, a structure shown in Table 4c below may be referred to. Table 4c is a table showing the layer thickness of the films in the set of dark reflection color, narrowband pass films, and this table reflects the layer structure of the set of bright reflection color, narrowband films of the set of narrowband pass films of the near-infrared narrowband filter of the present disclosure. Two film materials are alternately coated with different thicknesses to form a corresponding film set structure, wherein the two film materials are SiₓGe₁₋ₓ:H, a high refractive index material, and SiO₂, a low refractive index dielectric material. According to a 1931 CIE xyz system characterization, the double-sided coating filters prepared based on Table 4a and Table 4c are characterized as (0.222, 0.179, 12.33%) and (0.232, 0.183, 11.97%) when the incident light is incident at an angle of 0° and 30°, respectively, where *x* and *y* represent the chromaticity coordinates of the color, and z represents the brightness of the color. FIG. 6b is a diagram showing a relationship between reflectivity and wavelength of a filter coated with the set of dark reflection color, narrowband pass films provided in example 4 of the present disclosure.

**Table 4a: Layer thickness of film in a set of wideband pass films or a set of longband pass films, unit: nm**

| Layer number | 1 | 2 | 3 | 4 | 5 | 6 |
|---|---|---|---|---|---|---|
| Material | SiO₂ | Si:H | SiO₂ | Si:H | SiO₂ | Si:H |
| Thickness | 170.6 | 27.72 | 82.96 | 32.7 | 132.4 | 40.69 |
| Layer number | 6 | 7 | 8 | 9 | 10 | 11 |
| Material | SiO₂ | Si:H | SiO₂ | Si:H | SiO₂ | Si:H |
| Thickness | 101.55 | 31.19 | 119.83 | 37.6 | 122.7 | 34.77 |
| Layer number | 12 | 13 | 14 | 15 | 16 | 17 |
| Material | SiO₂ | Si:H | SiO₂ | Si:H | SiO₂ | Si:H |
| Thickness | 116.51 | 34.77 | 118.47 | 30.3 | 127.7 | 42.24 |
| Layer number | 18 | 19 | 20 | 21 | 22 | 23 |
| Material | SiO₂ | Si:H | SiO₂ | Si:H | SiO₂ | Si:H |
| Thickness | 123.15 | 26.47 | 105.93 | 42.1 | 126.9 | 35.13 |
| Layer number | 24 | 25 | 26 | - | - | - |
| Material | SiO₂ | Si:H | SiO₂ | - | - | - |
| Thickness | 74.04 | 22.29 | 94.59 | - | - | - |

**Table 4b: Layer thickness of film in a set of bright reflection color, narrowband pass films, unit: nm**

| Layer number | 1 | 2 | 3 | 4 | 5 |
|---|---|---|---|---|---|
| Material | SiO₂ | a-Si:H | SiO₂ | a-Si:H | SiO₂ |
| Thickness | 271.34 | 103.33 | 313.14 | 52.95 | 423.24 |
| Layer number | 6 | 7 | 8 | 9 | 10 |
| Material | a-Si:H | SiO₂ | a-Si:H | SiO₂ | a-Si:H |
| Thickness | 161.06 | 359.67 | 121.13 | 325.95 | 229.85 |
| Layer number | 11 | 12 | 13 | 14 | 15 |
| Material | SiO₂ | a-Si:H | SiO₂ | a-Si:H | SiO₂ |
| Thickness | 67.6 | 120.61 | 230.7 | 71.12 | 153.94 |
| Layer number | 16 | 17 | 18 | 19 | 20 |
| Material | a-Si:H | SiO₂ | a-Si:H | SiO₂ | a-Si:H |
| Thickness | 269.59 | 51.55 | 106 | 116.26 | 62.54 |
| Layer number | 21 | 22 | 23 | 24 | 25 |
| Material | SiO₂ | a-Si:H | SiO₂ | a-Si:H | SiO₂ |
| Thickness | 161.77 | 261.54 | 131.1 | 99.22 | 74.22 |
| Layer number | 26 | 27 | 28 | 29 | 30 |
| Material | a-Si:H | SiO₂ | a-Si:H | SiO₂ | a-Si:H |
| Thickness | 104.2 | 108.34 | 259.53 | 220.66 | 30.75 |
| Layer number | 31 | 32 | 33 | 34 | 35 |
| Material | SiO₂ | a-Si:H | SiO₂ | a-Si:H | SiO₂ |
| Thickness | 117.28 | 7.85 | 146.55 | 165.16 | 72.64 |
| Layer number | 36 | 37 | 38 | 39 | 40 |
| Material | a-Si:H | SiO₂ | a-Si:H | SiO₂ | a-Si:H |
| Thickness | 32.5 | 248 | 131.47 | 319.05 | 129.39 |

**Table 4c: Layer thickness of film in a set of dark reflection color, narrowband pass films, unit: nm**

| Layer number | 1 | 2 | 3 | 4 | 5 |
|---|---|---|---|---|---|
| Material | SiO₂ | SiₓGe₁₋ₓ:H | SiO₂ | SiₓGe₁₋ₓ:H | SiO₂ |
| Thickness | 120.77 | 155.9 | 50.95 | 95.41 | 21.38 |
| Layer number | 6 | 7 | 8 | 9 | 10 |
| Material | SiₓGe₁₋ₓ:H | SiO₂ | SiₓGe₁₋ₓ:H | SiO₂ | SiₓGe₁₋ₓ:H |
| Thickness | 26.69 | 209.01 | 107.21 | 211.07 | 120.06 |
| Layer number | 11 | 12 | 13 | 14 | 15 |
| Material | SiO₂ | SiₓGe₁₋ₓ:H | SiO₂ | SiₓGe₁₋ₓ:H | SiO₂ |
| Thickness | 33.7 | 78.37 | 158.44 | 150.94 | 45.52 |
| Layer number | 16 | 17 | 18 | | |
| Material | SiₓGe₁₋ₓ:H | SiO₂ | SiₓGe₁₋ₓ:H | SiO₂ | SiₓGe₁₋ₓ:H |
| Thickness | 79.6 | 149.8 | 65.1 | 155.1 | 135.2 |
| Layer number | 21 | 22 | 23 | 24 | 25 |
| Material | SiO₂ | SiₓGe₁₋ₓ:H | SiO₂ | SiₓGe₁₋ₓ:H | SiO₂ |
| Thickness | 152.95 | 68.3 | 61.26 | 64.19 | 170.69 |
| Layer number | 26 | 27 | 28 | 29 | - |
| Material | SiₓGe₁₋ₓ:H | SiO₂ | SiₓGe₁₋ₓ:H | SiO₂ | - |
| Thickness | 123.87 | 195.8 | 205.01 | 98.3 | - |

An example of the present disclosure also provides an optical system including an infrared image sensor and the aforementioned filter 5. The filter 5 is disposed on a photosensitive side of the infrared image sensor.

Referring to FIG. 7, FIG. 7 is a structural view of an optical system provided by an example of the present disclosure. As shown in FIG. 7, the optical system includes an infrared (Infrared Radiation, IR) light source 2, a first lens assembly 3, a second lens assembly 4, a filter 5 and a three-dimensional sensor 6. The light emitted by the infrared light source 2 is irradiated to a surface of a test object 1 through the first lens assembly 3. The light reflected from the surface of the test object 1 is irradiated to the filter 5 through the second lens assembly 4. The ambient light is cut off by the filter 5. The infrared or part of the red light passes through filter 5 and then irradiates to a photosensitive side of the three-dimensional sensor 6 to form image data that may be processed. The filter 5 has a relatively low center wavelength offset corresponding to oblique light in different directions. The transmitted infrared signal has a high signal-to-noise ratio, and the resulting image quality is good.

The foregoing is only a description of the preferred embodiments of the present disclosure and the applied technical principles. It should be appreciated by those skilled in the art that the protective scope of the present disclosure is not limited to the technical solutions formed by the particular combinations of the above technical features. The protective scope should also cover other technical solutions formed by any combinations of the above technical features or equivalent features thereof without departing from the concept of the technology, such as, technical solutions formed by replacing the features as disclosed in the present disclosure with (but not limited to), technical features with similar functions.

## Claims

1. A near-infrared narrowband filter, **characterized in that**, the near-infrared narrowband filter comprises:
a substrate;
a set of narrowband pass films, disposed at a first side of the substrate; and
a set of wideband pass films or a set of longwave pass films, wherein the set of wideband pass films is disposed at a second side of the substrate opposite to the first side, a passband of the set of wideband pass films is wider than that of the set of narrowband pass films, the set of longwave pass films is disposed at the second side of the substrate opposite to the first side, and a passband of the set of longwave pass films is wider than that of the set of narrowband pass films,
wherein the set of narrowband pass films comprises a high refractive index layer having a refractive index greater than 3 and a low refractive index layer having a refractive index less than 3 within a wavelength range of 780 nm to 3000 nm, and
wherein a reflection color of the near-infrared narrowband filter in a CIE xyz coordinate system satisfies:
x < 0.509;
y < 0.363, and
z < 50%.

2. The near-infrared narrowband filter according to claim 1, **characterized in that** the reflection color of the near-infrared narrowband filter in the CIE xyz coordinate system satisfies:
x < 0.509;
y < 0.363, and
z < 30%.

3. The near-infrared narrowband filter according to claim 1, **characterized in that** the set of narrowband pass films further comprises a middle refractive index layer, wherein:
a refractive index of the middle refractive index layer is between the refractive index of the high refractive index layer and the refractive index of the low refractive index layer.

4. The near-infrared narrowband filter according to claim 1, **characterized in that** the high refractive index layer is formed by one or more of silicon hydride, SiₓGe₁₋ₓ and SiₓGe₁₋ₓ: H, or
the high refractive index germanium-based layer is formed by one or more of germanium hydride, SiₓGe₁₋ₓ, and SiₓGe₁₋ₓ: H.

5. The near-infrared narrowband filter according to claim 1, **characterized in that** the low refractive index layer is formed by one or more of SiO₂, Si₃N₄, SiOₓN_{y}, Ta₂O₅, Nb₂O₅, TiO₂, Al₂O₃, SiCN and SiC.

6. The near-infrared narrowband filter according to claim 1, **characterized in that**, further comprises:
a plurality of middle refractive index layers having a refractive index ranging from 1.7 to 4.5 in the wavelength range of 780 nm to 3000 nm.

7. The near-infrared narrowband filter according to claim 3, **characterized in that** the middle refractive index layer is formed by one or more of a-SiOₓ:H_{y}, a-SiNₓ:H_{y}, a-GeOₓ:H_{y}, a-GeNₓ:H_{y}, a-Si_{z}Ge_{1-z}Oₓ:H_{y} and a-Si_{z}Ge_{1-z}Nₓ:H_{y}.

8. The near-infrared narrowband filter according to claim 1, **characterized in that** a center wavelength shift of the passband of the set of narrowband pass films is below 16 nm when an incident light enters the near-infrared narrowband filter at an angle of 0° to 30°.

9. The near-infrared narrowband filter according to claim 1, **characterized in that** center wavelength drifts of *p* light and *s* light of the near-infrared narrowband filter are below 5 nm.

10. The near-infrared narrowband filter according to claim 1, **characterized in that** a total thickness of the set of narrowband pass films and the set of wideband pass films or the set of longwave pass films is less than 15 µm .

11. A manufacturing method of a near-infrared narrowband filter, **characterized in that**, comprises:
coating alternately a low refractive index layer and a high refractive index layer on a first side of a substrate to form a set of narrowband pass films, and
coating a set of wideband pass films or a set of longwave pass films on a second side of the substrate opposite to the first side, wherein:
a passband of the set of wideband pass films or the set of longwave pass films is wider than that of the set of narrowband pass films;
the set of narrowband pass films comprises a high refractive index layer having a refractive index greater than 3 and a low refractive index layer having the refractive index less than 3 within a wavelength range of 780 nm to 3000 nm, and
a reflection color of the near-infrared narrowband filter in a CIE xyz coordinate system satisfies:
x < 0.509;
y < 0.363, and
z < 50%.

12. The manufacturing method according to claim 11, **characterized in that** the manufacturing method is a coating method by sputtering coating or evaporation coating.

13. The manufacturing method according to claim 11, **characterized in that** forming the set of narrowband pass films further comprises:
coating a middle refractive index layer, wherein a refractive index of the middle refractive index layer is between the refractive index of the high refractive index layer and the refractive index of the low refractive index layer.

14. The manufacturing method according to claim 13, **characterized in that**, further comprises:
bombarding a target with a charged ion beam obtained by glow discharge based on silicon, germanium, argon, hydrogen, and oxygen to coat the middle refractive index layer, wherein the middle refractive index layer comprises one or more of a-SiOₓ:H_{y}, a-SiNₓ:H_{y}, a-GeOₓ:H_{y}, a-GeNₓ:H_{y}, a-SizGe_{1-z}Oₓ:H_{y} and a-Si_{z}Ge_{1-z}Nₓ:H_{y}.
